# EUROPEAN PATENT APPLICATION

(11) **EP 2 157 841 A1**
(43) Date of publication of application: **24.02.2010**
(21) Application number: 08811125.7
(22) Date of filing: 24.09.2008
(51) Int. Cl.: H05K 3/34

(54) **SOLDER BALL MOUNTING METHOD**

(30) Priority: 30.05.2008 US 57479
(71) Applicant: IBIDEN CO., LTD., Ogaki-shi Gifu 503-0917 (JP)
(72) Inventor: SAWA, Shigeki, Ibi-gun Gifu 501-0695 (JP); TANNO, Katsuhiko, Ibi-gun Gifu 501-0695 (JP); KIMURA, Osamu, Ibi-gun Gifu 501-0695 (JP); KURIBAYASHI, Koji, Ibi-gun Gifu 501-0695 (JP)
(74) Representative: Grünecker, Kinkeldey, Stockmair & Schwanhäusser Anwaltssozietät
(86) International application number: PCT/JP2008/067170
(87) International publication number: WO 2009/144846

(57) **Abstract**

A flux 79 is applied on each connection pad group 75g except for a contact portion between a spacer 86 and a printed wiring board 10. For this reason, the flux is not attached on the spacer 86. Therefore, when the mask is detached from the printed wiring board, the printed wiring board needs not to be inverted, and damage to the solder resist layer 70 cannot be occur. In addition, the heights of the solder ball 78 and the upper surface of the mask 80 are equalized by using the spacer 86, so that it is possible to surely load the solder balls one by one on the electrode pad 75 and to reduce a probability of occurrence of defects that solder balls are not loaded or that a plurality of the solder balls are loaded.

## Description

### [Field of the Invention]

The present invention relates to a solder ball loading method for loading a solder ball to be made into solder bumps on a printed wiring board.

### [Related Art]

Solder bumps are used for electrical connection between a printed wiring board and an IC chip. The solder bumps are formed through the following processes.
(1) A process of printing a flux on a connection pad formed on a printed wiring board.
(2) A process of loading a solder ball on the connection pad with the flux printed thereon.
(3) A process of forming a solder bump from the solder ball by performing reflow.

In the aforementioned process of loading the solder ball on the load-receivingmember, for example, as disclosed in Patent Document 1, a mask having openings for dropping the solder ball on the load-receiving member is used. In the mask disclosed in the Cited Document 1, a spacer is formed from a plurality of protrusions. Therefore, practically, when the solder balls are loaded on the load-receiving member, the mask is aligned with the load-receiving member so that the protrusions are disposed between adjacent electrode portions.
[Patent Document 1]
   Japanese Patent Application Publication No. 2006-324618

### [Disclosure of the Invention]

### [Problems to Be Solved by the Invention]

In the Cited Document 1, the flux needs to be locally applied to only the electrode portions so that the flux cannot be attached on the mask (spacer). However, it is preferable that, for simplifying the processes, the flux is applied overall to the electrode-portion formation region. In this case, if the mask disclosed in the Cited Document 1 is used, the flux may be attached at distal ends of protrusions, so that it is difficult to detach the mask from the board. In addition, due to a stress at the time of detaching the mask, the board may be inverted. In addition, when the mask is detached from the board, due to resilience thereof, the solder balls may deviate from the electrode portions.

An object of the present invention is to provide a solder ball loading method capable of surely loading solder balls on connection pads.

### [Means for Solving the Problems]

In order to achieve the above object, the invention of Claim 1 provides a solder ball loading method for loading a solder ball to be made into solder bumps on connection pads of a printed wiring board, comprising steps of: applying a flux on a surface of the connection pad of the printed wiring board; preparing a mask including a mask main body having an opening group including a plurality of openings corresponding to the connection pads and a spacer having an opening portion exposing the opening group; aligning the mask with the printed wiring board so that the openings of the mask main body face the connection pads; and supplying the solder ball to the mask and dropping the solder ball on the connection pad through the openings of the mask main body.

### [Effects of the Invention]

In the solder ball loading method according to the present invention, the flux can be applied overall on the connection pad formation regions of the printed wiring board. In comparison with a case where the flux is locally applied on each of the connection pads, it is possible to simplify the manufacturing processes. In addition, since the connection pad on which the flux is not applied cannot be occur, it is possible to surely load the solder ball on each of the connection pads.

In addition, the spacer and the mask main body are integrally formed, so that it is possible to accurately control the height of the mask and to equalize the heights of the solder balls and the upper surface of the mask. Accordingly, it is possible to surely load the solder balls one by one on the connection pad and to reduce a probability of occurrence of defects that solder balls are not loaded or that a plurality of the solder balls are loaded.

### [Best Embodiments for Carrying Out the Invention]

### [First Embodiment]

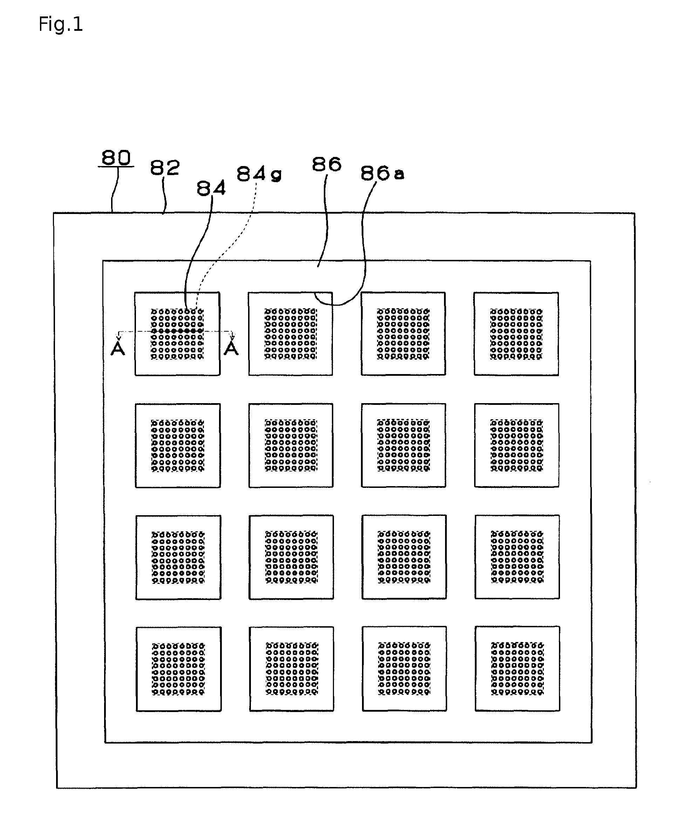

A mask for loading solder balls on a printed wiring board according to a solder ball loading method of a first embodiment is described with reference to FIGS. 1 to 7.

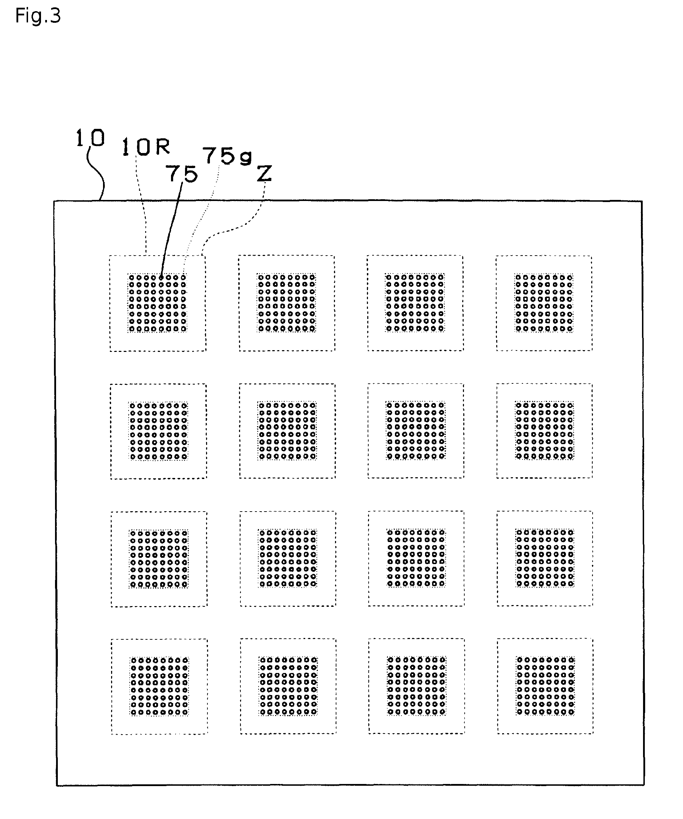

FIG. 3 illustrates a sheet-sized printed wiring board 10 where the solder balls are loaded by using the mask according to the first embodiment. For example, the sheet-sized printed wiring board 10 is a printed wiring board for gang printing to manufacture 4x4 piece-sized printed wiring boards 10R. In the figure, 16 printed wiring boards 10R cut along dotted lines Z are manufactured. In the central portion of each printed wiring board 10R, a connection pad formation region 75g is disposed. A plurality of connection pads 75 on which the solder balls are loaded are formed in the connection pad formation region. The connection pad formation region denotes a specific region having a minimum area among the region including the entire connection pads of the printed wiring board.

FIG. 1 is a rear view illustrating a mask 80 according to the first embodiment which is used to load the solder balls on the printed wiring board illustrated in FIG. 3. The mask 80 includes a mask main body 82 where opening groups 84g including openings 84 corresponding to the connection pads 75 of the printed wiring board 10 are formed and a spacer 86 where opening portions 86a for exposing the opening group 84g are formed. The mask main body 82 and the spacer 86 are integrally formed. Here, the term "integrally" includes formation of the two members by the same process, formation of the two members with the same material, and separate fixation of the different members.

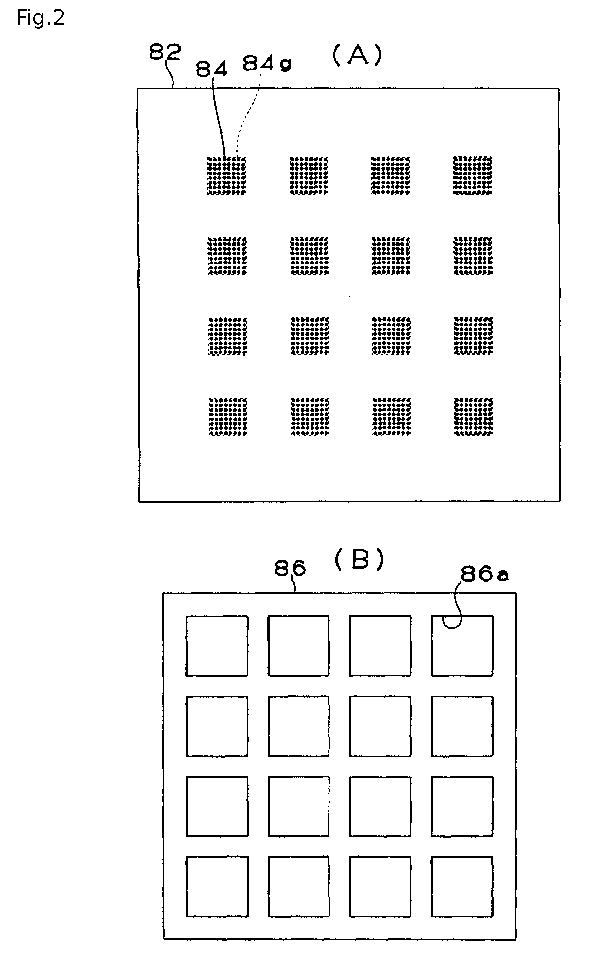

FIG. 2 separately illustrates the mask main body 82 and the spacer 86, FIG. 2 (A) is a plan view of the mask main body 82, and FIG. 2 (B) is a plan view of the spacer 86.

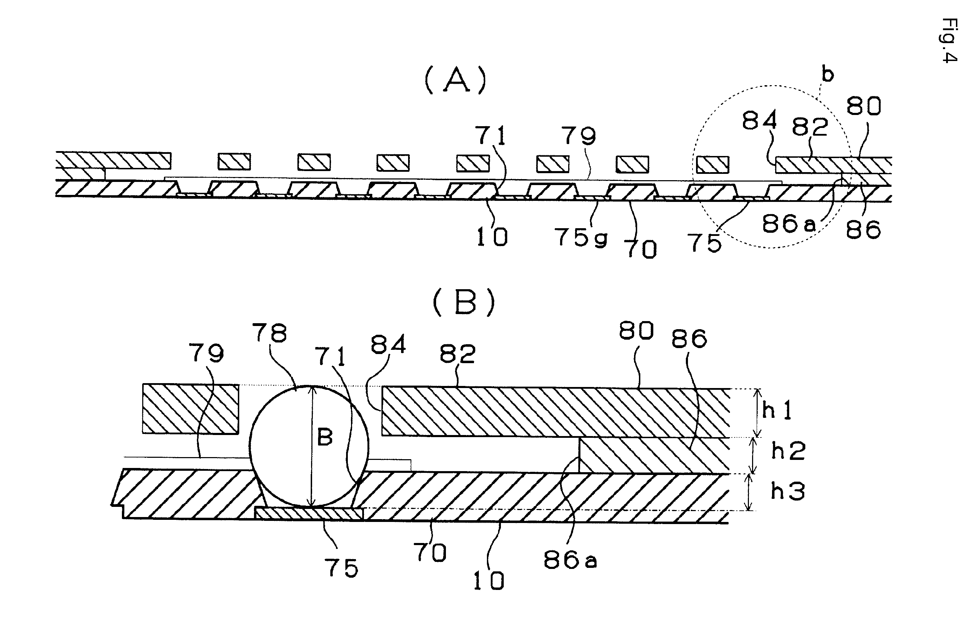

FIG. 4 (A) is a view corresponding to a cross section A-A among FIG. 1, illustrating a state that the mask 80 is loaded on the printed wiring board 10, and FIG. 4 (B) is an enlarged view illustrating a portion indicated by a circle b in FIG. 4 (A). A solder resist layer 70 is formed on a surface of the printed wiring board 10, and the connection pads 75 are exposed by openings formed on the solder resist layer 70. The flux 79 is applied on the entire connection pad formation region 75g of the printed wiring board 10. The region where the flux is applied is smaller than the opening portion of the spacer. Namely, in the printed wiring board 10, the flux 79 is applied on the connection pad formation region 75g except for portions that are in contact with the spacer 86.

In the first embodiment, the flux 79 is applied on the connection pad formation region 75g except for the contact portions between the spacer 86 and the printed wiring board 10. Therefore, since the flux is not applied to the spacer 86, when the mask is detached from the printed wiring board, defects such are inversion of the printed wiring board, misalignment of solder balls on the connection pad, and damage to the solder resist layer 70 cannot occur.

As shown in FIG. 4 (B), a thickness of the mask 80 is designed so that, in the state that the solder balls 78 are loaded on the connection pads 75, a height of the upper surface of the mask 80 and a height of the vertexes of the solder balls 78 are substantially equal to each other. For example, in a case where the solder ball 78 has a diameter B of 70 µm, a thickness h1 of the mask main body 82, a thickness h2 of the spacer 86, and a thickness h3 of the solder resist layer from the connection pad 75 are designed to be 25 µm, 30 µm, and 15 µm, respectively. In addition, the "vertex of the solder ball" denotes a portion of a surface of a solder ball, where its height is in maximum.

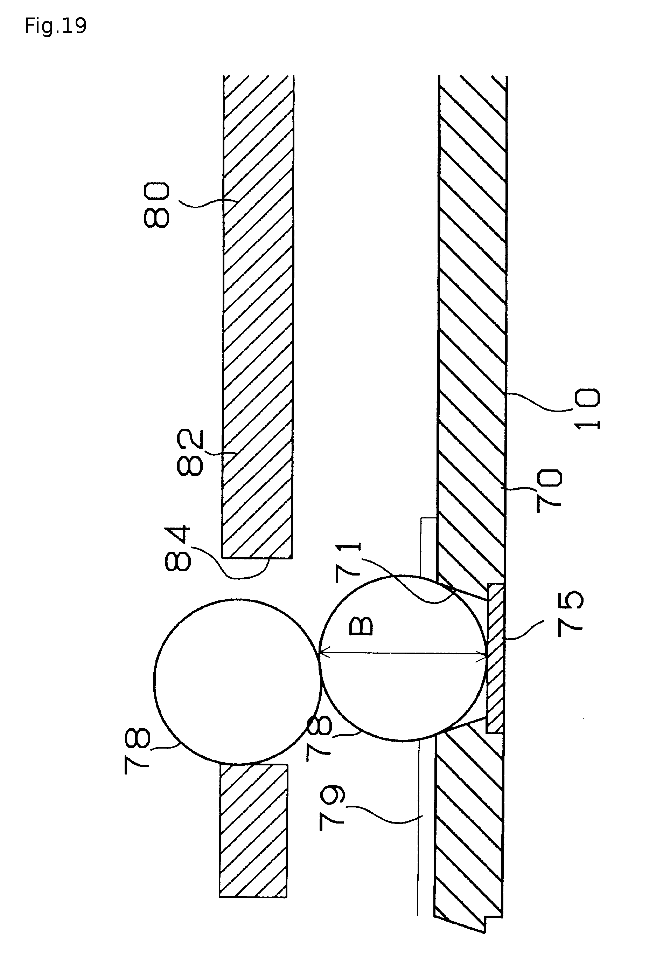

According to the solder ball loading method of the first embodiment, the heights of the solder ball 78 and the upper surface of the mask 80 are equal to each other, so that a predetermined amount (one by one) of solder balls can be surely loaded on the electrode pad 75. In addition, it is possible to reduce a probability of occurrence of defects that solder balls are not loaded or that a plurality of the solder balls are loaded. On the other hand, as shown in FIG. 19, in a case where the height of the upper surface of the mask 80 is larger than the height of the solder ball 78, other solder balls may be loaded on the solder balls loaded on the connection pads through the openings of the mask main body. Therefore, in a case where the solder balls are protruded from the upper surface of the mask 80, loading of solder balls on other connection pads may be difficult and it is not preferable. In addition, in this state, if reflow is performed, solder bumps having large volume exceeding a predetermined volume are formed, so that the yield may be lowered.

In addition, it is preferable that a diameter of the opening of the mask main body is 1.2 times to 1.5 times larger than a diameter of a solder ball. Namely, for example, in a case where solder balls having a diameter of 70 µm is used, the diameter of opening is suitably in a range of 84 to 105 µm. Therefore, the solder balls can be surely loaded on the connection pads one by one. Here, a diameter of "1.2 times less than" may cause the defect that the solder balls are not loaded on the connection pads. On the other hand, a diameter of "1.5 times larger than" may increase a probability that a plurality of solder balls are loaded on the connection pad.

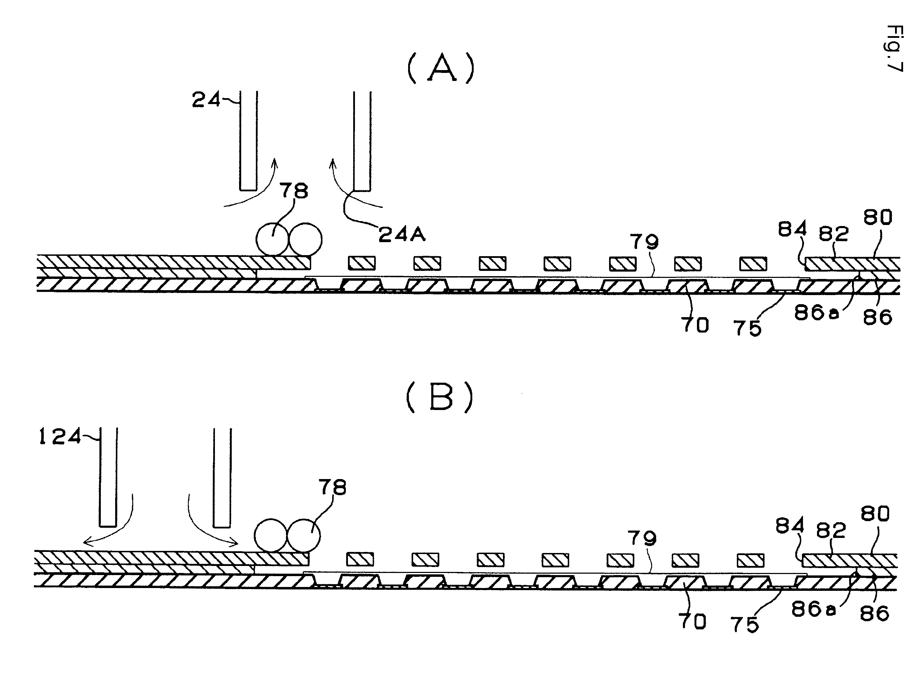

FIG. 7 (A) is a view for explaining loading of solder balls by using the mask 80 according to the first embodiment. A tube member 24 having an opening portion 24A facing the mask is positioned over the mask 80. Air is absorbed through the tube member 24, so that the solder balls 78 are collected on the mask that are disposed just under the tube member 24. The tube member 24 is moved in a horizontal direction relatively to the mask 80. Accordingly, the collected solder balls 78 are moved on the mask 80 and dropped on the connection pads 75. FIG. 7 (B) illustrates a modified example of the first embodiment. In FIG. 7 (A), the air is absorbed by the tube member 24. However, in the modified example, the air is ejected from the tube member 24, and thus, the solder balls 78 are carried, so that the solder balls 78 are dropped on the connection pads 75.

According to the solder ball loading method of the first embodiment, a tube member 24 is disposed over the mask 80, and air is absorbed through an opening portion of the tube member 24, so that the solder balls 78 can be collected. The tube member 24 is moved in a horizontal direction, so that the collected solder balls 78 are moved on the mask 80. Accordingly, the solder balls 78 are dropped on the connection pad 75 through the opening 84 of the mask. For this reason, fine solder balls can be surely loaded on the entire connection pads of the printed wiring board. In addition, since the solder balls are moved in a non-contact manner, unlike the case of using a squeegee, the solder balls can be loaded on the connection pads without damage to the solder balls, and the height of the solder bumps can be maintained uniformly. In addition, even in a case of a printed wiring board having large unevenness thereon such as a build-up multilayer wiring board, the solder balls can be suitably loaded on the connection pads.

In the first embodiment, since the portions for formation of the opening groups 84g of the mask main body 82 which are formed corresponding to the opening portion 86a of the spacer 86 are supported by the spacer 86 in the four directions and hardly deflected, a distance between the mask main body 82 and the printed wiring board 10 can be maintained uniformly. Particularly, although air is absorbed by the tube member 24, air flow through the gap between the mask 80 and the printed wiring board 10 is blocked by the spacer 86. In addition, the distance between the mask main body and the printed wiring board can always be maintained uniformly without floating of the mask main body by the air flow through the opening group from the lower portion of the mask.

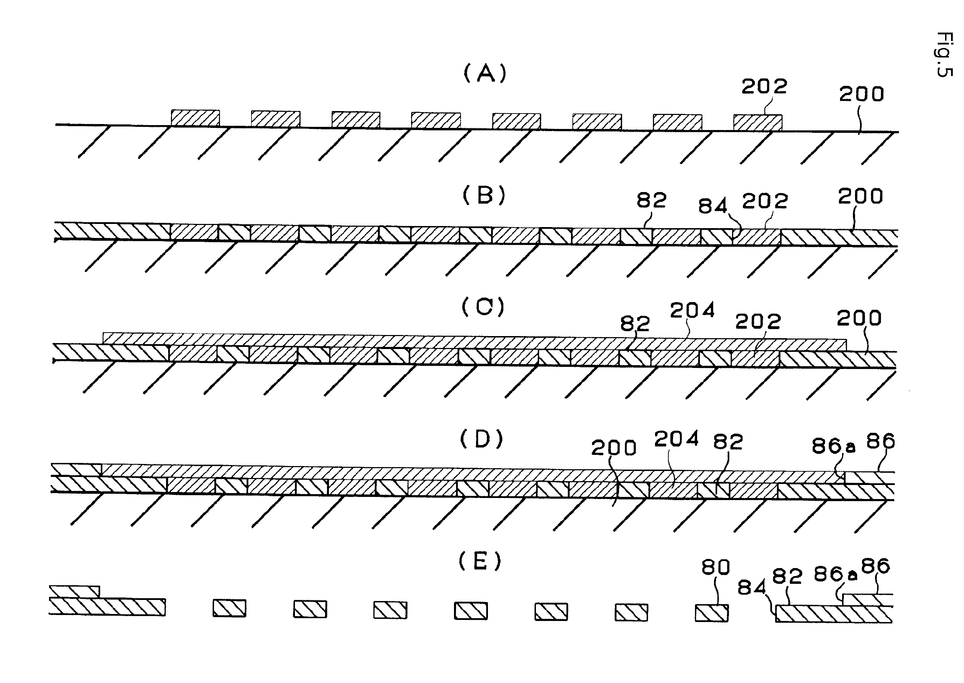

A method for manufacturing the mask 80 of the first embodiment will be described with reference to FIG. 5.
A plating resist 202 for forming the openings 84 of the mask is formed on an SUS plate 200 that is subjected to surface treatment (FIG. 5(A)). In this state, the mask main body 82 having the openings 84 is formed by using a nickel alloy electrolytic plating method (FIG. 5 (B)). Next, the plating resist 204 to be made into the opening portion of the spacer is formed on the mask main body 82 (FIG. 5 (C)). Next, the spacer 86 having the opening portion 86a is formed by using the nickel alloy electrolytic plating method (FIG. 5 (D)). The plating resist 202 and the plating resist 204 are dissolved by using a predetermined solution, and after that, the mask 80 having the spacer 86 and the mask main body 82 is detached from the SUS plate 200 (FIG. 5(E)). In this manner, the spacer 86 and the mask main body 82 are integrally formed by the plating, so that the thickness thereof can be accurately adjusted.

In the first embodiment, the spacer 86 and the mask main body 82 are integrally formed. However, the spacer and the mask main body that are separately formed can be adhered by using, for example, ultrasonic adhesion or an adhesive. Alternatively, the spacer and the mask main body may be formed with different materials. For example, the mask main body can be formed by using a metal, and the spacer can be formed by using a resin.

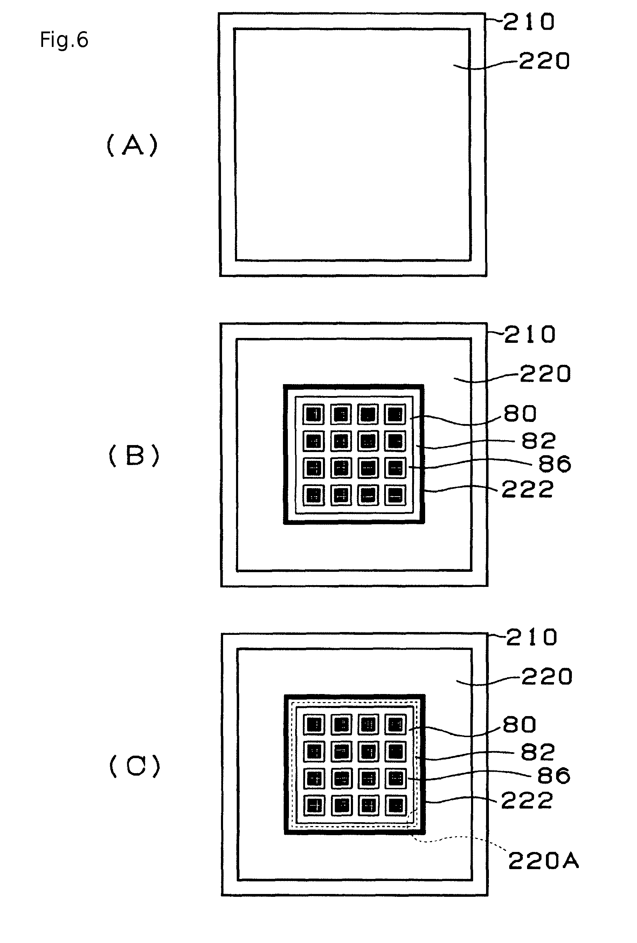

Attachment of the mask to a supporting mechanism will be described with reference to FIG. 6. As shown in FIG. 6 (A), the supporting mechanism is formed by using a material formed by adhering with a nylon cloth 220 to a frame 210 with a uniform tension exerted thereto. As shown in FIG. 6 (B), the mask 80 is adhered at the center of the nylon cloth 220 by using an adhesive 222. The adhesive 222 is applied to an outer side of the spacer 86 in the outer circumference of the mask main body 82. Finally, as shown in FIG. 6 (C), the opening 220A is formed in the nylon cloth 220 in an inner side of the adhesive 222, so that uniform tension of the nylon cloth 220 can be exerted to the mask 80.

In the first embodiment, as shown in FIG. 6 (B) and FIG. 1, an outer circumference of the mask main body 82 is extended over the outer circumference of the spacer 86. Tension is exerted to the outer circumference of the mask main body 82 that is extended over the outer circumference of the spacer 86, so that uniform tension can be exerted to a portion of the mask main body where the spacer exists and to a portion where the opening portion of the spacer is disposed. Accordingly, uniform tension can be exerted on the entire portions of the mask main body. As a result, deflection due to the difference of tension can be suppressed, and a height of the mask main body can be accurately controlled, and the height of the solder ball and the height of the mask can also be equal to each other.

### [Second Embodiment]

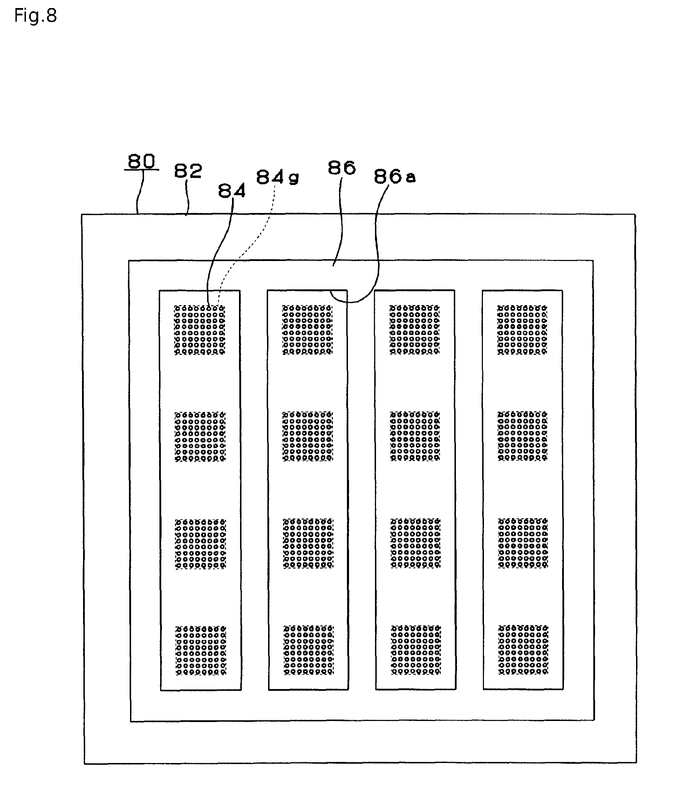

A mask according to a second embodiment will be described with reference to FIG. 8 illustrating a rear surface of the mask. In the first embodiment, each of the opening portions 86a of the spacer 86 is individually formed on each of the opening groups 84g of the mask main body. However, in the second embodiment, opening portions 86a are formed in the spacer 86 so that a plurality of opening groups 84g of the mask main body can be exposed overall.

### [Third Embodiment]

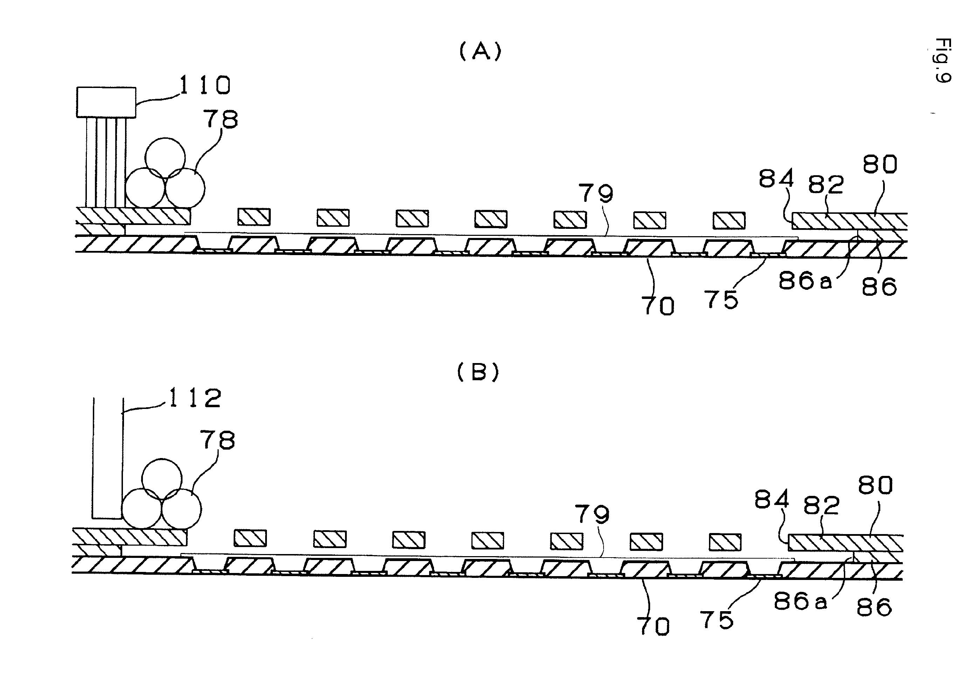

A solder ball loading method according to a third embodiment will be described with reference to FIG. 9 (A). In the first embodiment, the solder balls are moved by the air flow. However, in the third embodiment, solder balls are loaded on connection pads by a brush 110.

### [Modified Example of Third Embodiment]

A solder ball loading method according to a modified example of the third embodiment will be described with reference to FIG. 9 (B). In the modified example of the third embodiment, solder balls are loaded on the connection pads by using a flexible squeegee 112.

### [Fourth Embodiment]

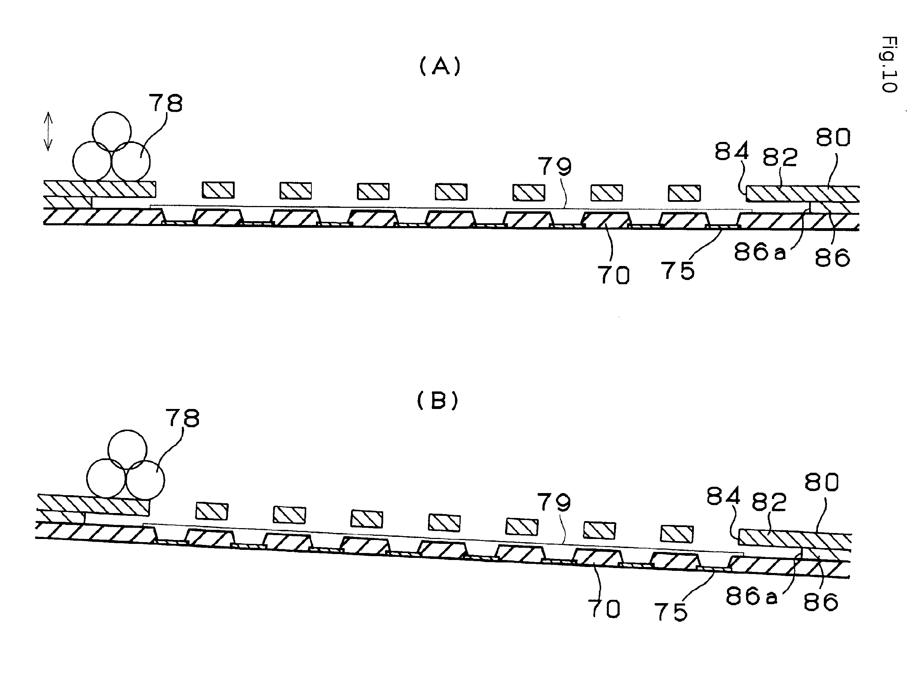

A solder ball loading method according to a fourth embodiment will be described with reference to FIG. 10 (A). In the first embodiment, the solder balls are moved by the air flow. However, in the fourth embodiment, solder balls are loaded on connection pads by vibrating a mask 80 and a printed wiring board.

### [Modified Example of Fourth Embodiment

A solder ball loading method according to a modified example of the fourth embodiment will be described with reference to FIG. 10(B). In the modified example of the fourth embodiment, solder balls are carried by slantingly moving a mask 80 and a printed wiring board.

### [First Example]

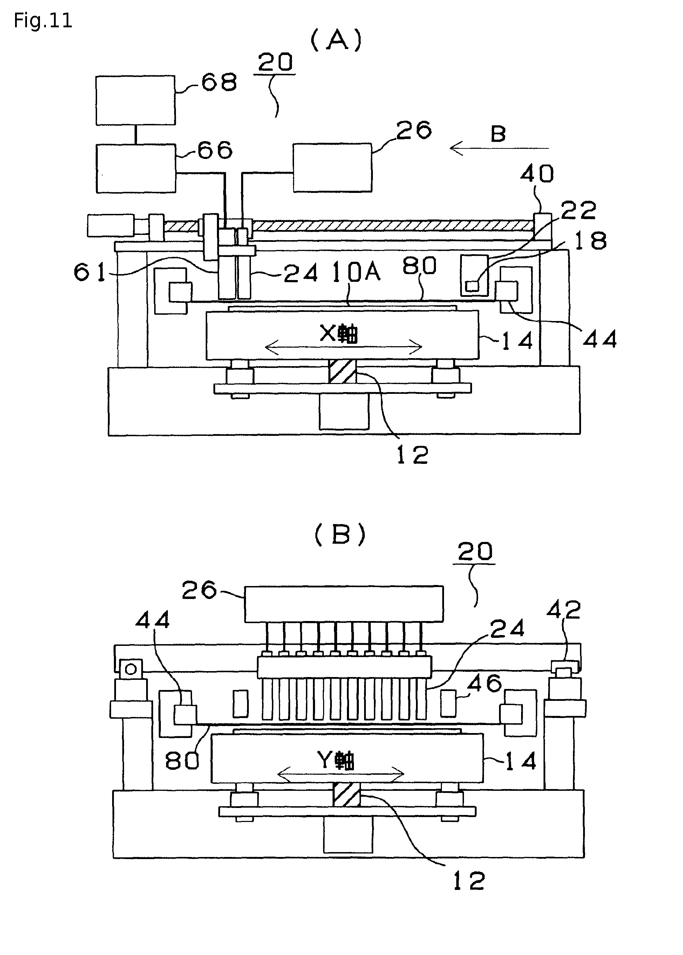

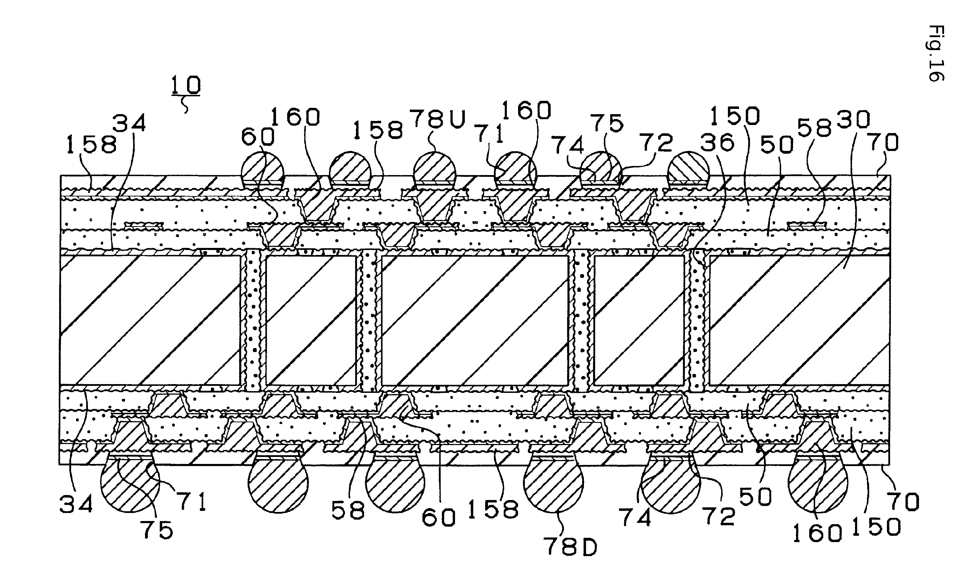

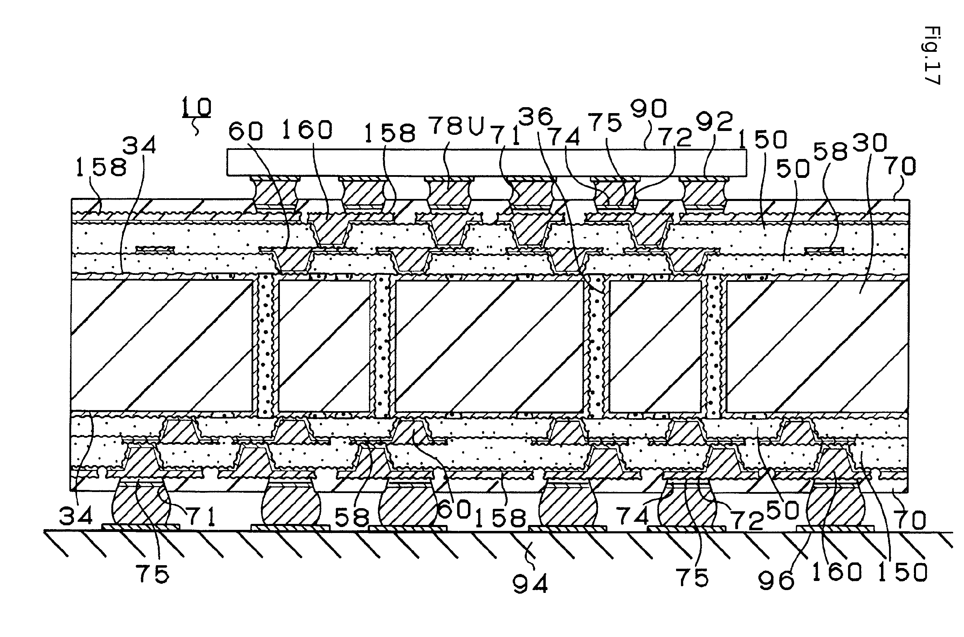

Next, a first example of the present invention will be described with reference to FIGS. 11 to 17. Firstly, a construction of a multilayer printed wiring board 10 manufactured by using a solder ball loading method according to the first example of the present invention will be described with reference to FIGS. 16 and 17. FIG. 16 is a cross-sectional view illustrating of the multilayer printed wiring board 10, and FIG. 17 is a view illustrating a state that an IC chip 90 is attached on the multilayer printed wiring board 10 shown in FIG. 16 and mounted on a daughter board 94. In the multilayer printed wiring board 10 shown in FIG. 16, conductor circuits 34 are formed on both surfaces of a core board 30. Front and rear surfaces of the core board 30 are connected to each other via through holes 36.

In addition, a conductor circuit 58 as a conductor circuit layer is formed through an interlayer resin insulating layer 50 on the conductor circuit 34 of the core board 30. A conductor circuit 58 is connected to the conductor circuit 34 through via holes 60. A conductor circuit 158 is formed on the conductor circuit 58 through an interlayer resin insulating layer 150. The conductor circuit 158 is connected to the conductor circuit 58 through via holes 160 formed on the interlayer resin insulating layer 150.

A solder resist layer 70 is formed on upper layers of the via-holes 160 and the conductor circuit 158. A nickel plating layer 72 and a gold plating layer 74 are disposed on the openings 71 of the solder resist layer 70, so that the connection pads 75 are formed. The solder bumps 78U are formed on the connection pads 75 of the upper surface thereof, and the solder bumps 78D are formed on the connection pads 75 of the lower surface thereof.

As shown in FIG. 17, the solder bumps 78U on the upper surface of the multilayer printed wiring board 10 are connected to electrodes 92 of the IC chip 90. On the other hand, the solder bumps 78D on the lower surface thereof are connected to lands 90 of the daughter board 94.

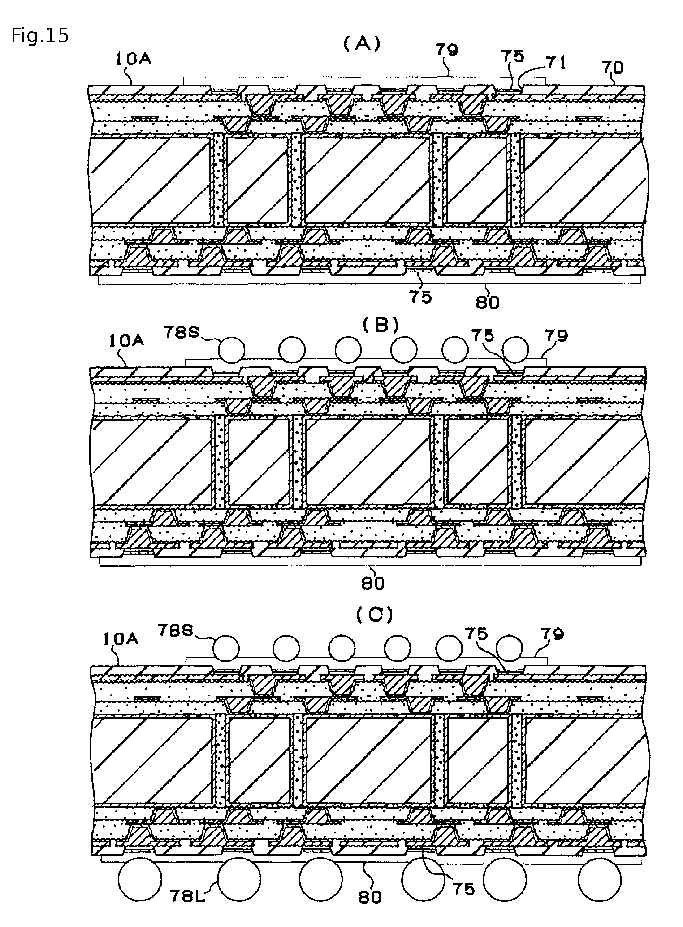

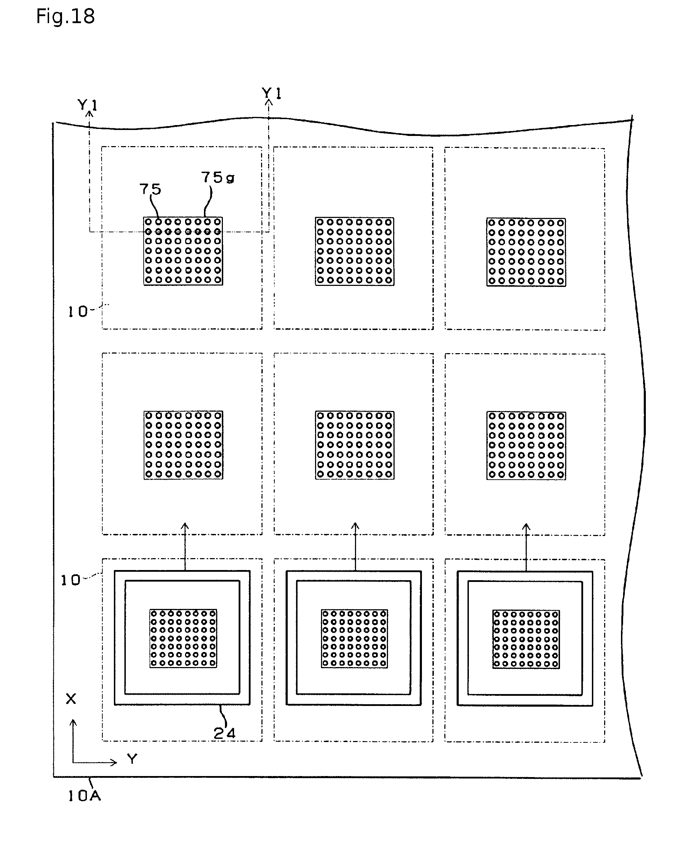

FIG. 18 is a plan view illustrating a (sheet-sized) multilayer printed wiring board 10A for gang printing. The multilayer printed wiring board 10A is divided into individual (piece size) multilayer printed wiring boards 10 having connection pad formation regions 75g where connection pads 75 are arrayed in matrix by cutting along a one dotted line in the figure. FIG. 15 is a view for explaining a process of forming the solder bumps on the multilayer printed wiring board 10A for gang printing and corresponds to a cross-sectional view taken along line Y1-Y1 of FIG. 18. As shown in FIG. 15 (A), the flux 79 is printed overall on a surface including the openings 71 of the solder resist layer 70 and a surface of the connection pads 75. As shown in FIG. 15 (B), fine solder balls 78s (for example, a solder ball manufactured by Hitachi Metals, LTD., having a diameter of equal to or larger than 40 µmΦ and less than 200 µmΦ) are loaded on the connection pads 75 on the upper side of the multilayer printed wiring board 10A by using a solder ball loading apparatus described later. In this case, if the solder ball has a diameter of less than 40 µmΦ, the solder ball is too light to be dropped on the connection pad. On the other hand, if the solder ball has a diameter of larger than 200 µmΦ, the solder ball is too heavy to be collected in the tube member, and thus, connection pads on which a solder ball is not loaded exist. In the present invention, it is important to use solder balls having a diameter of equal to or larger than 40 µmΦ and less than 200 µmΦ. The range is useful for fining the solder balls resulting from the reduction of the diameter of the opening 71 of the solder resist layer 70. In addition, since the solder balls are small, it is difficult to adsorb the solder balls by using a method of loading the solder balls on the connection pads by adsorbing the solder balls by using an absorption pad. Therefore, it can be understood that the method according to the example is more effective.

Next, as shown in FIG. 15 (C), solder balls 78L having a typical diameter (25 µm) are adsorbed and loaded on the connection pads 75 of the lower side of the multilayer printed wiring board 10A by using a conventional absorption pad (for example, Patent No. 1975429). Next, the solder balls are heated by a reflow furnace, and as shown in FIG. 16, for example, 500 ∼ 30000 of solder bumps 78U are formed with a pitch of equal to or larger than 60 µm and less than 200 µm on the upper side of the multilayer printed wiring board 10A. In addition, for example, 250 of solder bumps 78D are formed with a pitch of 2 mm on the lower side thereof. If the pitch is less than 60 µm, it is difficult to manufacture the solder balls that are suitable for the pitch. If the pitch is equal to or larger than 200 µm, the solder balls can be manufactured without problems according to the present invention, but the solder balls can be manufactured by a conventional method. In addition, as shown in FIG. 17, the multilayer printed wiring board 10A for gang printing is divided into individual multilayer printed wiring boards 10, and the IC chip 90 is mounted through the solder bumps 78U by reflow. After that, the multilayer printed wiring board 10 on which the IC chip 90 are mounted is attached on the daughter board 94 through the solder bumps 78D.

A solder ball loading apparatus for loading fine solder balls 78s (having a diameter of less than 200 µm) on the connection pads of the multilayer printed wiring board that are described above with reference to FIG. 15 (B) will be described with reference to FIG. 11. FIG. 11 (A) is a view illustrating a construction of a solder ball loading apparatus according to the solder ball loading method of the first example, and FIG. 11 (B) is a view illustrating the solder ball loading apparatus of FIG. 11 (A) as seen from arrow B.

The solder ball loading apparatus 20 includes an XYθ absorption table 14 for positioning and supporting the multilayer printed wiring board 10A, an up/down moving axis 12 for lifting the XYθ absorption table 14, a ball alignment mask having openings corresponding to connection pads 75 of the multilayer printed wiring board, a loading tube (tube member) 24 for inducing the solder balls moving on the ball alignment mask 80, a absorbing box 26 for pressing the loading tube 24, a absorbed ball removing tube 61 for recovering redundant solder balls, an absorbing box 66 for pressing the absorbed ball removing tube 61, an absorbed ball removing absorption apparatus 68 of holding the recovered solder balls, a mask clamp 44 for clamping the ball alignment mask 80, an X direction moving axis 40 for moving the loading tube 24 and the absorbed ball removing tube 61 in the X direction, a moving axis support guide 42 for supporting the X direction moving axis 40, a alignment camera 46 for photographing the multilayer printed wiring board 10, a remaining amount detection sensor 18 for detecting a remaining amount of the solder balls below the loading tube 24, and a solder ball supplying apparatus 22 for supplying the solder balls to the loading tube 24 based on the remaining amount detected by the remaining amount detection sensor 18. In the solder ball loading apparatus 20 shown in FIG. 11, only the X direction moving axis 40 for moving the loading tube 24 and the absorbed ball removing tube 61 in the X direction, but moving mechanisms for moving the loading tube and the absorbed ball removing tube in the Y direction may be provided. In addition, for the moving in the X and Y directions, the loading tube 24 may be fixed, and the side of the ball alignment mask 80 and the printed wiring board may be moved.

FIG. 1 is a rear view illustrating the mask 80 used for the solder ball loading apparatus 20 shown in FIG. 11. The mask 80 includes a mask main body 82 where opening groups 84g made of openings 84 corresponding to the connection pads 75 of the printed wiring board 10 are formed and a spacer 86 where opening portions 86a for exposing the opening groups 84a are formed. The mask main body 82 and the spacer 86 are integrally formed.

FIG. 4 (A) corresponds to a cross section taken along line A-A of FIG. 1 and illustrates a state that the mask 80 is mounted on the printed wiring board 10. FIG. 4 (B) is an enlarged view of a portion indicated by a circle b in FIG. 4(A).
The solder resist layer 70 is formed on a surface of the printed wiring board 10, and the connection pads 75 are formed so as to the solder resist layer 70 is exposed from the openings 71 of the solder resist layer 70. The flux 79 is applied on the connection pad formation region 75g including the connection pads 75 for one piece. Namely, in the present invention, the flux is applied on each of the connection pads except for contact portions between the spacer and the printed wiring board. An area of the flux applied region is smaller than an area of the opening portion of the spacer.

For this reason, the flux is not attached on the spacer 86. Therefore, when the mask is detached from the printed wiring board, the printed wiring board needs not to be inverted, and damage to the solder resist layer 70 cannot be occur.

In addition, in a case where the solder balls are dropped on the connection pads, as shown in FIG. 4 (B), a height of the vertexes of the solder balls and a height of a surface of the mask main body are substantially equal to each other. According to the solder ball loading method of the first example, the heights of the solder ball 78 and the upper surface of the mask 80 are equalized to each other, so that it is possible to surely load a predetermined amount (one by one) of the solder balls on the electrode pad 75 and to reduce a probability of occurrence of defects that solder balls are not loaded or that a plurality of the solder balls are loaded.

In the first example, the loading tube 24 is made of a conductive metal such as SUS stainless, Ni, and Cu, and the loading tube is grounded at a side of the solder ball loading apparatus 20. When the solder balls are moved and carried on the ball alignment mask 80, the solder balls may be electrically charged due to collision therebetween. However, solder balls having small diameter and light weight are not attached on the loading tube 24 electro-statically. Therefore, the solder balls can be surely loaded on the printed wiring board.

As shown in the plan view of FIG. 18, a plurality of loading tubes 24 (although not shown, the absorbed ball removing tubes 61 are also disposed similarly to the loading tubes) of the solder ball loading apparatus 20 corresponding to each of the connection pad formation regions 75g are disposed on the sheet-sized multilayer printed wiring board 10A in the Y direction. In addition, although one loading tube 24 corresponds to one connection pad formation region 75g, the loading tube 24 may be designed to have a size corresponding to a plurality of the connection pad formation regions 75g. Here, the Y direction is selected for the convenience of description, and thus, the loading tubes may be disposed in the X direction.
In addition, the XYθ absorption table 14 shown in FIG. 11 positions, holds, and corrects the multilayer printed wiring board 10 where the solder balls are loaded. The alignment camera 46 detects the alignment marks of the multilayer printed wiring board 10 on the XYθ absorption table 14 and adjusts a positions between the multilayer printed wiring board 10 and the ball alignment mask 80 based on the detected position. The remaining amount detection sensor 18 detects the remaining amount of the solder balls by using an optical method.

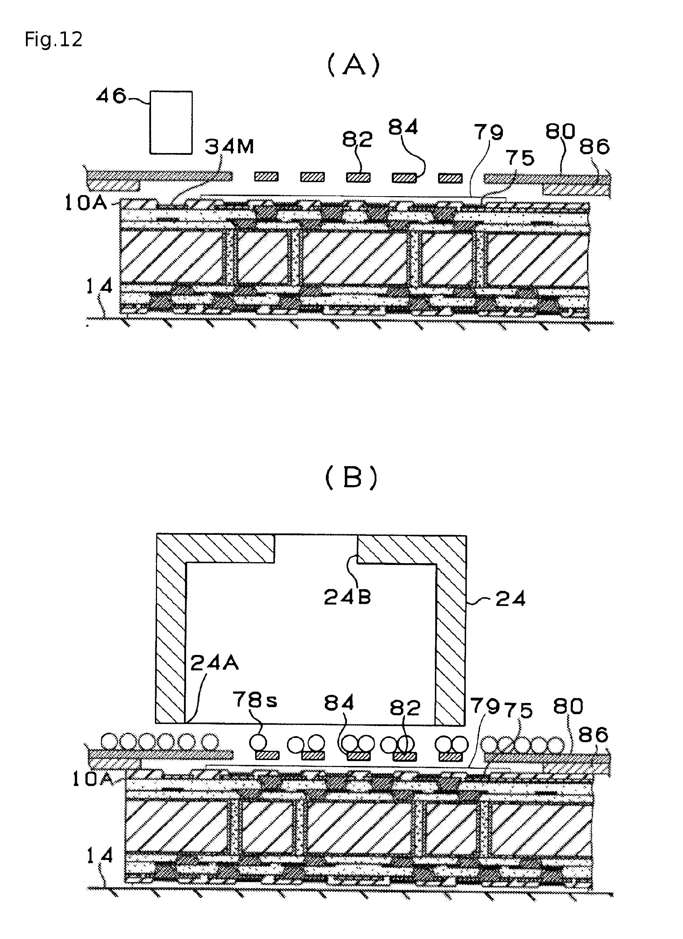

Next, the solder ball loading process using the solder ball loading apparatus 20 will be described with reference to FIGS. 12 to 14.

### (1) Identifying and Correcting of Position of Multilayer Wiring Board

As shown in FIG. 12(A), alignment marks 34M of multilayer printed wiring board 10A for gang printing are identified by the alignment camera 46, and position of the multilayer printed wiring board 10A with respect to the ball alignment mask 80 is corrected by the XYθ absorption table 14. Namely, the position is adjusted so that the openings 84 of the ball alignment mask 80 correspond to the connection pads 75 of the multilayer printed wiring board 10A.

### (2) Supplying of Solder Balls

As shown in FIG. 12 (B), the solder ball supplying apparatus 22 supplies a predetermined amount of the solder balls 78s to the side of the loading tube 24. Alternatively, the solder balls may be supplied in the loading tube in advance.

### (3) Loading of Solder Balls

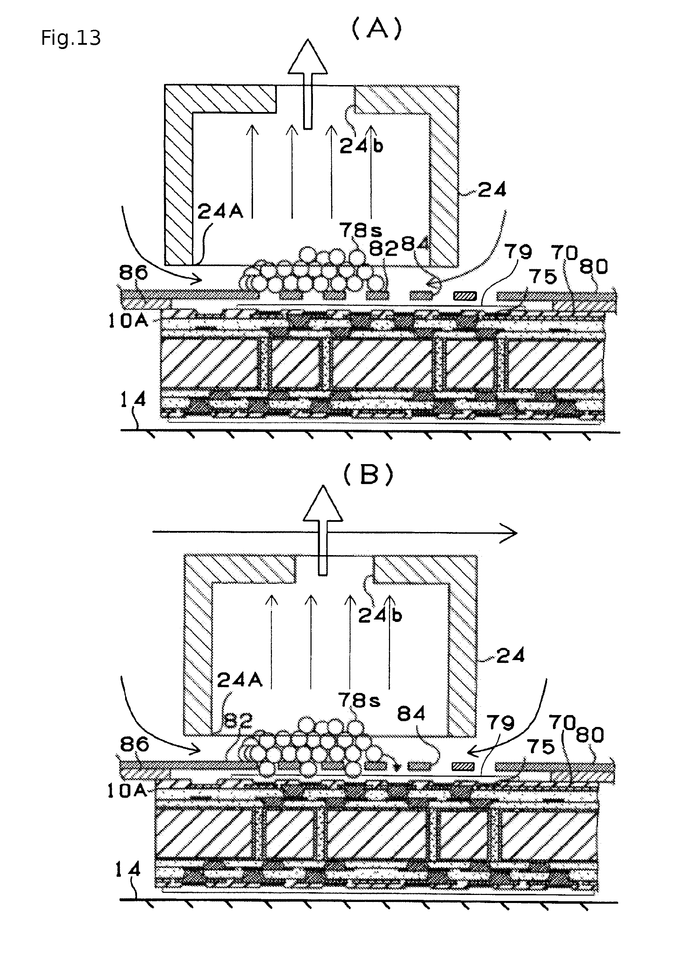

As shown in FIG. 13(A), the loading tube 24 is positioned over the ball alignment mask 80 while maintaining a predetermined clearance (for example, 0.5 times to 4 times a diameter of ball) to the ball alignment mask. Air is absorbed by the absorption portion 24b, so that air flow rate at the gap between the loading tube and the ball alignment mask is in a range of 5 m/sec to 35 m/sec. Accordingly, the solder balls 78s are collected on the ball alignment mask 80 that is disposed just below the opening portion 24A of the loading tube 24.

Next, as shown in FIGS. 13 (B), 14 (A), and 18, the loading tubes 24 that are disposed along the Y axis of the multilayer printed wiring board 10A shown in FIGS. 11 (B) and (A) are moved in the horizontal direction along the X axis by the X direction moving axis 40. Therefore, the solder balls 78s collected on the ball alignment mask 80 are moved according to the moving of the loading tubes 24. The solder balls 78s are dropped and loaded on the connection pads 75 of the multilayer printed wiring board 10A through the openings 84 of the ball alignment mask 80. Accordingly, the solder balls 78s can be sequentially aligned on the entire connection pads of the side of the multilayer printed wiring board 10A.

### (4) Removing of Attached Solder Balls

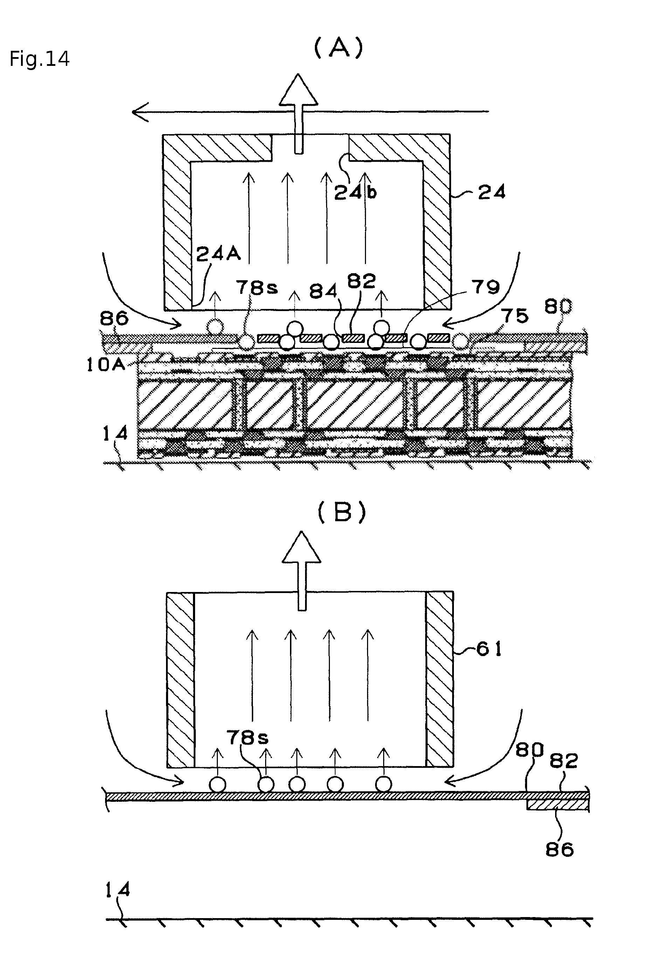

As shown in FIG. 14 (B), redundant solder balls 78s are induced to positions of the ball alignment mask 80 where the openings do not exist by the loading tubes 24, and after that, absorbed and removed by the absorbed ball removing tubes 61.

### (5) Detachment of Board

The multilayer printed wiring board 10A is detached from an XYθ absorption table 14.

According to the solder ball loading method of the first example, the loading tube 24 is positioned over the ball alignment mask 80, and air is absorbed by the absorption portion 24B (see FIG. 12 (B)) of the loading tube 24, so that the solder balls 78s are collected. In this state, the loading tube 24 is moved in the horizontal direction, so that the collected solder balls 78s are moved on the ball alignment mask 80. The solder balls 78s are dropped through the openings 84 of the ball alignment mask 80 on the connection pads 75 of the multilayer printed wiring board 10A. For this reason, the fine solder balls 78s can be surely loaded on the entire connection pads 75 of the multilayer printed wiring board 10A. In addition, since the solder balls 78s are moved in a non-contact manner, unlike the case of using a squeegee, the solder balls can be loaded on the connection pads without damage to the solder balls, and the height of the solder bumps 78U can be maintained uniformly. For this reason, a product manufactured according to the present invention has good performance for electronic parts such as ICs in terms of a mount-ability and an environment-resistance test such as a heat cycle test after mounting and a high temperature/high humidity test. In addition, even in a case of a multilayer printed wiring board having unevenness on a surface thereof, the solder balls can be suitably loaded on the connection pads without dependency on flatness of a product. In addition, since the fine solder balls can be surely loaded on the connection pads, even in case of a printed wiring board having a connection pad pitch of 60 µm to 150 µm and a diameter of opening of the solder resist of less than 150 µm, solder bumps having uniform heights can be formed on the printed wiring board.

In addition, since the solder balls are induced by the absorbing force, it is possible to prevent the solder balls from being agglutinated or adhered. In addition, since the number of loading tubes 24 can be adjusted, the present invention can be adapted to various sheet-sizedmultilayer printed wiring boards. For this reason, the present invention can be flexibly used for multi-product, small-lot-sized production.

### [First Example -1]

### (1) Manufacturing of Printed Wiring Board

As a starting material, a both-side copper layered board (for example, MCL-E-67 manufactured by **Hitachi Chemical** Co., LTD.) is used. Through-hole conductors and conductor circuits are formed on the board by using a well-known method. Next, interlayer insulating layers and conductor circuit layers are alternately laminated thereon by using a well-known method (for example, Build-Up Multilayer Printed Wiring Board" written by Takaki Kiyo, published on July 20, 2000 by NIKKAN KOGYO SHIMBUN, LTD), and connection pads for electrical connection to ICs are formed on the outmost conductor circuit layer. Next, a solder resist layer having openings (for example, 150 µmΦ) is formed so as to expose the connection pads.

### (2) Loading of Solder Balls

(1) Acommercially-available rosin-based flux is applied on connection pad formation regions of the manufactured printed wiring board. Next, the printed wiring board is mounted on the aforementioned absorption table of the solder ball loading apparatus according to the present invention. The alignment marks of the printed wiring board and the ball alignment mask are identified by using a CCD camera, and the printed wiring board and the ball alignment mask are aligned with each other. The ball alignment mask has a spacer on a rear surface thereof. As the ball alignment mask, a Ni mask having openings having a diameter of 110 µm at the positions corresponding to the connection pads of the printed wiring board is used. Although the Ni metal mask is used, a SUS or polyimide ball alignment mask can be used. In addition, it is preferable that a diameter of the openings formed on the ball alignment mask is 1.2 times to 1.5 times a diameter of the used ball. Next, a SUS loading tube having a size (1.1 times to 4 times a size of the connection pad formation region) substantially corresponding to the connection pad formation region and a height of 200 mm is positioned over the metal mask ( ball alignment mask) with a clearance of 0.5 times to 4 times a diameter of a solder ball. In addition, for example, Sn63Pb37 solder balls (manufactured by Hitachi Metals, LTD.) having a diameter of ball of 80 µmΦ are loaded on the peripheral ball alignment masks. In addition, although Sn/Pb solders are used for the solder balls in the first example -1, the composition of the solder balls is not limited thereto, but any Pb-free solder selected from a group consisting of Sn and Ag, Cu, In, Bi, Zn, and the like may be used.

The air is absorbed by the absorption portion (5 to 20 mmΦ) 24B (see FIG. 12 (B)) on the upper portion of the loading tube, and the solder balls are collected on the ball alignment mask in the loading tube.

Next, the loading tube is moved at a speed of 20 mm/sec, so that the solder balls are moved. The solder balls are dropped through the opening portion of the ball alignment mask, so that the solder balls are loaded on the connection pads. In the first example -1, the loading tube 24 is made of a conductive metal such as a SUS stainless, Ni, and Cu, and the loading tube is grounded at the side of the solder ball loading apparatus 20. Next, after the redundant solder balls on the ball alignment mask are removed, the solder ball alignment mask and the printed wiring board are separately detached from the solder ball loading apparatus. In addition, the solder balls loaded on the connection pads are subject to reflow at a temperature of, for example, 230 °C, so that predetermined solder bumps are formed.

### [Brief Description of the Drawings]

[FIG. 1]
   FIG. 1 is a rear view illustrating a mask according to a first embodiment.
[FIG. 2]
   FIG. 2 separately illustrates a mask main body and a spacer, FIG. 2 (A) is a plan view of the mask main body, and FIG. 2(B) is a plan view of the spacer.
[FIG. 3]
   FIG. 3 is a plan view illustrating a multilayer printed wiring board for gang printing where solder balls are loaded by using a mask according to the first embodiment.
[FIG. 4]
   FIG. 4 (A) is a view corresponding to a cross section A-A among FIG. 1, illustrating a state that a mask 80 is loaded on a printed wiring board 10, and FIG. 4 (B) is an enlarged view illustrating a portion indicated by a circle b in FIG. 4 (B).
[FIG. 5]
   FIG. 5 is a view illustrating steps of a method for manufacturing a mask according to the first embodiment.
[FIG. 6]
   FIG. 6 is a view for explaining a step of fixing the mask according to the first embodiment on a frame.
[FIG. 7]
   FIG. 7 (A) is a view for explaining loading of solder balls by using the mask according to the first embodiment, and FIG. 7 (B) is a view for explaining loading of solder balls according to a modified example of the first embodiment.
[FIG. 8]
   FIG. 8 is a rear view illustrating a mask according to a second embodiment.
[FIG. 9]
   FIG. 9 (A) is a view for explaining loading of solder balls by using a mask according to a third embodiment, and FIG. 9 (B) is a view for explaining loading of solder balls according to a modified example of the third embodiment.
[FIG. 10]
   FIG. 10 (A) is a view for explaining loading of solder balls by using a mask according to a fourth embodiment, and FIG. 10 (B) is a view for explaining loading of solder balls according to a modified example of the fourth embodiment.
[FIG. 11]
   FIG. 11 (A) is a constructional view illustrating a construction of a solder ball loading apparatus according to the first embodiment of the present invention, and FIG. 11 (B) is a view illustrating the solder ball loading apparatus as seen from an arrow B of FIG. 11 (A).
[FIG. 12]
   FIG. 12 (A) is a view for explaining alignment of a multilayer printed wiring board, and FIG. 12 (B) is a view for explaining supplying of solder balls to a loading tube.
[FIG. 13]
   FIG. 13 (A) is a view for explaining collecting of solder balls by using a loading tube, and FIG. 13 (B) is a view for explaining collecting and inducing of solder balls by using a loading tube.
[FIG. 14]
   FIG. 14 (A) is a view for explaining dropping of solder balls on connection pads, and FIG. 14 (B) is a view for explaining removing of solder balls by using a absorbed ball removing tube.
[FIG. 15]
   FIGS. 15 (A), (B), and (C) are views for explaining processes of manufacturing a multilayer printed wiring board.
[FIG. 16]
   FIG. 16 is a cross-sectional view illustrating a multilayer printed wiring board.
[FIG. 17]
   FIG. 17 is a cross-sectional view illustrating a state that an IC chip is attached on a multilayer printed wiring board illustrated in FIG. 16 and the board is mounted on a daughter board.
[FIG. 18]
   FIG. 18 is a plan view illustrating a multilayer printed wiring board for gang printing.
[FIG. 19]
   FIG. 19 is a view for explaining dropping of solder balls when a height of solder balls is larger than that of the mask.

### [Reference Numerals]

10: printed wiring board
20: solder ball loading apparatus
22: solder ball supplying apparatus
24: loading tube(tube member)
75: connection pad
75g: connection pad group
80: ball alignment mask
82: mask main body
84: opening
86: spacer
78s: solder ball

## Claims

1. A solder ball loading method for loading a solder ball to be made into solder bumps on connection pads of a printed wiring board, comprising steps of:
applying a flux on a surface of the connection pad of the printed wiring board;
preparing a mask including a mask main body having an opening group including a plurality of openings corresponding to the connection pads and a spacer having an opening portion exposing the opening group;
aligning the mask with the printed wiring board so that the openings of the mask main body face the connection pads; and
supplying the solder ball to the mask and dropping the solder ball on the connection pad through the openings of the mask main body.

2. The solder ball loading method according to Claim 1, wherein the spacer is integrally formed on the mask main body.

3. The solder ball loading method according to Claim 1 or 2, wherein, when the solder ball is dropped on the connection pad, a vertex of the solder ball is positioned at a height substantially equal to that of the surface of the mask main body.

4. The solder ball loading method according to any one of Claims 1 to 3, wherein the flux is applied on the entire connection pad formation region.

5. The solder ball loading method according to any one of Claims 1 to 4, wherein the flux is applied on each connection pad except for a contact portion between the spacer and the printed wiring board.

6. The solder ball loading method according to any one of Claims 1 to 5, wherein the flux applied region is smaller than the opening portion of the spacer.

7. The solder ball loading method according to any one of Claims 1 to 5, wherein a diameter of the opening of the mask main body is 1.2 times to 1.5 times a diameter of the solder ball.

8. The solder ball loading method according to any one of Claims 1 to 7, wherein an outer circumference of the mask main body is further extended over an outer circumference of the spacer.

9. The solder ball loading method according to Claim 1 or 2, wherein in the step of dropping the solder ball on the connection pad, a tube member having an opening portion facing the mask is positioned over the mask, air is absorbed by the tube member to collect the solder balls on the mask disposed just below the tube member, the tube member is moved in the horizontal direction with respect to the mask to move the collected solder balls on the mask, and the solder balls are dropped on the connection pads.
